# DEMANDE DE BREVET EUROPEEN

(11) **EP 4 783 456 A1**
(43) Date de publication de la demande: **29.07.2026**
(21) Numéro de dépôt: 26166394.2
(22) Date de dépôt: 24.03.2017
(51) Int. Cl.: H02S 30/10, H02S 40/44

(54) **PANNEAU SOLAIRE HYBRIDE ÉQUIPÉ D'UN DISPOSITIF DE FIXATION D'UN ÉCHANGEUR THERMIQUE**

(30) Priorité: 24.03.2016 FR 1652532
(62) Demande divisionnaire de: 17719649.0
(71) Demandeur: Dualsun, 13453 Marseille Cedex (FR)
(72) Inventeur: BROTTIER, Laetitia, 13453 Marseille Cedex 13 (FR); MOUTERDE, Jérôme, 13453 Marseille Cedex 13 (FR)
(74) Mandataire: Roman, Alexis

(57) **Abrégé**

Panneau solaire hybride (P) comprenant :
- un module photovoltaïque (1) comportant une face avant (12) et une face arrière (11),
- un échangeur thermique (2) comportant une face inférieure (21) et une face supérieure (22), ladite face supérieure (22) étant disposée en vis-à-vis de la face arrière (11) du module photovoltaïque (1),
- un cadre rigide (8) encadrant le module photovoltaïque (1) et l'échangeur thermique (2),
- au moins un élément élastique (3) adapté pour exercer une force de compression contre la face inférieure (21) de l'échangeur (2) de sorte que ledit échangeur (2) soit plaqué contre la face arrière (11) du module photovoltaïque (1),
- l'élément élastique (3) prend appui contre au moins un élément d'appui (4), ledit élément d'appui (4) étant en liaison avec le cadre (8) de sorte qu'au moins une partie de la force de compression exercée par l'élément élastique (3) sur l'élément d'appui (4) soit reprise par ledit cadre (8),
- l'élément d'appui (4) est disposé sous l'échangeur (2) et s'étend dans la largeur et/ou la longueur dudit échangeur (2),
- ledit panneau comporte au moins trois éléments d'appui disposés sous l'échangeur et qui s'étendent chacun dans la largeur ou respectivement dans la longueur dudit échangeur, lesquels éléments d'appui se présentent sous la forme de profilés installés à intervalles réguliers dans la longueur, ou respectivement dans la largeur, dudit échangeur,
- le cadre présente une face inférieure adaptée pour être positionnée contre un support de fixation du panneau (P),
- les éléments d'appui sont configurés de sorte que lorsque lesdits éléments d'appui sont contraints par l'élément élastique, ils ne dépassent pas le plan contenant la face inférieure dudit cadre.

## Description

### Domaine technique de l'invention.

L'invention a pour objet un panneau solaire hybride équipé d'un dispositif de fixation d'un échangeur thermique.

Elle concerne le domaine technique des systèmes d'assemblage de panneaux solaires hybrides.

### État de la technique.

Les panneaux solaires photovoltaïques permettent de produire une énergie électrique à partir du rayonnement solaire. Ils comprennent une pluralité d'éléments photovoltaïques (cellules ou couches minces) qui fonctionnent selon le principe de l'effet photoélectrique. Généralement, plusieurs éléments photovoltaïques sont reliés entre eux sur un panneau solaire photovoltaïque, et plusieurs panneaux sont reliés pour créer une installation solaire. Cette installation produit de l'électricité qui peut être consommée sur place ou alimenter un réseau de distribution.

Les panneaux solaires photovoltaïques ne convertissent qu'une faible part du rayonnement solaire en électricité, le reste étant de la chaleur non utilisée. Cette chaleur est défavorable à la performance électrique des panneaux solaires puisqu'on peut constater une diminution de l'efficacité des éléments photovoltaïques avec la température d'environ -0.45%/°C. C'est pourquoi il est doublement intéressant de refroidir les panneaux solaires photovoltaïques. En effet, non seulement l'efficacité des éléments photovoltaïques croît, mais les calories du refroidissement peuvent être utilisées dans des systèmes de chauffage plus ou moins complexes. On parle alors de panneaux solaires hybrides capables de produire simultanément une énergie électrique et une énergie thermique.

Généralement, un échangeur thermique est disposé en vis-à-vis de la face arrière du module photovoltaïque de façon à refroidir ce dernier. Le document brevet WO 2012/069750 (SOLAIRE 2G) propose un panneau solaire hybride composé d'un échangeur thermique en contact avec les éléments photovoltaïques. De manière générale l'échangeur thermique est fixé au module photovoltaïque grâce à des procédés divers tels que le collage ou encore la lamination directe (la lamination étant un procédé typique connu dans le domaine du photovoltaïque).

De tels procédés permettent, en plus de solidariser l'échangeur au module photovoltaïque, d'éviter la présence d'air et ainsi améliorer la performance thermique. Toutefois, ces techniques ont comme inconvénients de nécessiter une épaisseur de colle (ou de polymère) importante.

Différentes techniques permettent de palier aux déformations engendrées par la dilatation des différentes parties du panneau lors de son utilisation :
- des colles permettant de solidariser un échangeur fabriqué dans un matériau dont le coefficient de dilatation est éloigné de celui de la face avant du module photovoltaïque (comme par exemple le cuivre, l'aluminium ou encore un matériau polymère) ont été développées. Toutefois, ces colles sont extrêmement onéreuses et augmentent considérablement le prix de fabrication du panneau solaire hybride ;
- le document brevet FR 1156550 (SOLAIRE 2G) propose l'utilisation de colles moins onéreuses. Toutefois, celles-ci sont uniquement efficaces pour coller deux matériaux ayant des coefficients de dilatation proches ;
- le document brevet WO 2009149572 (IDS HOLDING AG) propose un panneau dans lequel l'échangeur est morcelé afin de limiter la dilatation entre le verre et l'aluminium. Un tel panneau est cependant extrêmement compliqué à fabriquer et mettre en place.

Toutes les techniques précitées présentent des inconvénients tels que le très important cout de revient, la difficulté de mise en place, ou encore la limitation du type de matériau pouvant être utilisé. Le document brevet DE 10 2011 122 126 (PA-ID AUTOMATION & VERMARKTUNG GMBH) propose un dispositif palliant à certains de ces inconvénients. Il propose un panneau solaire comprenant :
- un module photovoltaïque,
- un échangeur thermique disposé contre le module photovoltaïque,
- un cadre rigide encadrant le module photovoltaïque et l'échangeur,
- et deux éléments élastiques en prise directe avec le cadre et adaptés pour exercer une force de compression contre l'échangeur de manière à le plaquer contre le module photovoltaïque.

Toutefois, le placage obtenu grâce à un tel dispositif n'est pas uniforme sur toute la surface de l'échangeur puisqu'il ne comporte que deux éléments élastiques exerçant une force de compression en des segments bien précis. Le rendement d'un tel panneau solaire hybride n'est donc pas optimal.

Un panneau solaire hybride est décrit dans l'article, A. KROISS ET AL : « Development of a seawater-proof Hybrid Photovoltaic/thermal (PV/T) Solar Collector », ENERGY PROCEDIA, vol. 52; 1 janvier 2014 (2014-01-01), pages 93-103. Ce panneau solaire hybride est composé d'un module photovoltaïque contre lequel est plaqué un échangeur. Pour plaquer l'échangeur, des barres contre lesquelles des ressorts sont en appui sont utilisées. Les barres sont fixées sur la face arrière d'un cadre rigide grâce à un système de vis.

D'autres panneaux solaires similaires sont décrits dans les documents brevets DE 10 2011 107393 (SOLVIS) et US 2015/349178 (RUBIO).

On notera que les panneaux solaires décrits dans l'article A. KROISS ET AL et dans le brevet US 2015/349178 précités, les profilés contre lesquels prennent appui les éléments élastiques sont situés hors du cadre de sorte que ce dernier ne peut pas être convenablement fixé sur des supports standards de fixation.

L'invention vise à remédier à cet état des choses. En particulier, un objectif de l'invention est de proposer un panneau solaire hybride dont la face inférieure du cadre peut être convenablement fixée sur un support standard de fixation lors de l'installation du panneau, et notamment sur un support plan.

Un autre objectif de l'invention est d'améliorer l'uniformité du placage de l'échangeur thermique contre le module photovoltaïque.

Encore un autre objectif de l'invention est d'améliorer l'échange thermique entre le module photovoltaïque et l'échangeur thermique.

Encore un autre objectif de l'invention est d'obtenir un panneau solaire hybride performant dont les coûts de fabrication sont limités.

Un objectif supplémentaire de l'invention est d'obtenir un panneau solaire hybride robuste dont la conception est simplifiée et dont l'esthétisme est amélioré.

Un autre objectif de l'invention est d'obtenir un panneau solaire hybride pouvant utiliser des matériaux aux coefficients de dilatation ayant des valeurs éloignées.

### Divulgation de l'invention.

La solution proposée par l'invention est un panneau solaire hybride selon la revendication 1.

La face inférieure du cadre peut être convenablement fixée sur un support standard de fixation lors de l'installation du panneau, et notamment sur un support plan. En effet, dans la mesure où les profilés ne dépassent pas le plan, toute la face inférieure du cadre est correctement positionnée en appui contre le support de fixation, sans contact ponctuel. En outre, la conception spécifique du panneau permet d'obtenir un placage plus uniforme de l'échangeur contre le module photovoltaïque. Les forces de compression des différents éléments élastiques étant appliquées sur toute la surface dudit échangeur et non pas en des segments localisés comme dans le document brevet DE 10 2011 122 126 (PA-ID AUTOMATION & VERMARKTUNG GMBH) précité.

D'autres caractéristiques avantageuses de l'invention sont listées dans les revendications secondaires.

### Description des figures.

D'autres avantages et caractéristiques de l'invention apparaîtront mieux à la lecture de la description d'un mode de réalisation préféré qui va suivre, en référence aux dessins annexés, réalisés à titre d'exemples indicatifs et non limitatifs et sur lesquels :
- la figure 1 est une représentation schématique en coupe des différentes couches formant le module photovoltaïque,
- la figure 2 est une vue schématique de dessous d'un panneau solaire hybride conforme à l'invention, les éléments d'appui se présentant sous la forme de profilés,
- la figure 3a est une vue en coupe selon B-B du panneau solaire hybride de la figure 2,
- la figure 3b est une vue en coupe selon A-A du panneau solaire hybride de la figure 2,
- les figures 4a et 4b sont des variantes du panneau de la figure 2,
- la figure 5 est une vue schématique de dessous d'un panneau solaire hybride conforme à l'invention, l'élément d'appui se présentant sous la forme d'une plaque,
- la figure 6a est une vue en coupe selon B-B du panneau solaire hybride de la figure 5,
- la figure 6b est une vue en coupe selon A-A du panneau solaire hybride de la figure 5,
- la figure 7 est une vue schématique en coupe d'un panneau solaire hybride conforme à l'invention,
- la figure 8a est une vue en coupe selon A-A du panneau solaire hybride de la figure 7,
- la figure 8b est une vue en coupe d'une variante du panneau solaire hybride de la figure 8a,
- la figure 9 est une vue schématique en coupe d'une variante du panneau solaire hybride de l'invention, un moyen de blocage étant installé sur l'échangeur,
- la figure 10 est une vue agrandie du moyen de blocage de la figure 9,
- la figure 11 est une vue en coupe selon C-C du moyen de blocage de la figure 10,
- la figure 12 est une vue schématique en coupe d'une variante du panneau solaire hybride, des éléments isolants étant placés entre les éléments d'appui,
- la figure 13a est une vue schématique en coupe d'une variante du panneau solaire hybride, une plaque de protection étant placée entre les éléments élastiques et l'échangeur,
- la figure 13b est une vue schématique en coupe d'une variante du panneau solaire hybride, des coupelles de protection étant placées entre chaque élément élastiques et l'échangeur,
- la figure 14 est une vue schématique en coupe d'une variante du panneau solaire hybride, des éléments de maintien étant placés entre les éléments d'appui et les éléments élastiques,
- la figure 15 est une variante du moyen de blocage de la figure 10.

### Modes préférés de réalisation de l'invention.

Le panneau solaire P objet de l'invention est un panneau solaire hybride connu de l'état de la technique, c'est-à-dire qu'il est capable de produire simultanément une énergie électrique et une énergie thermique. Il est destiné à être utilisé seul ou en combinaison avec d'autres panneaux similaires, de façon à ce que l'énergie électrique et thermique qu'il produit soient exploitables par une habitation ou une installation.

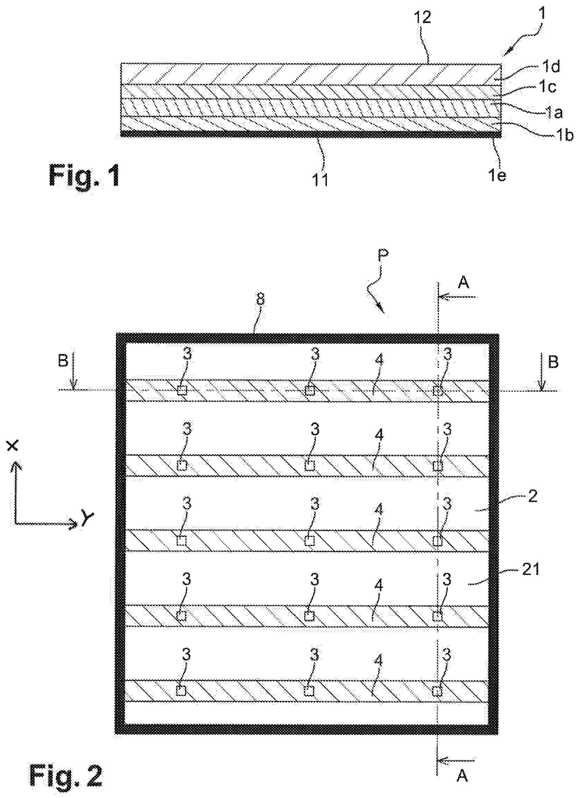

En se rapportant aux figures annexées et notamment à la figure 1, le panneau solaire **P** comporte un module photovoltaïque **1** présentant une face avant **12** et une face arrière **11.** La face avant **12** est laissée libre de façon à ce qu'elle puisse recevoir le rayonnement solaire. Environ 80% de l'énergie solaire reçue est dissipée dans le panneau **P.** La présence d'un échangeur thermique **2** placé en vis-à-vis de la face arrière **11** du module photovoltaïque **1** permet de récupérer la chaleur accumulée ou dissipée dans le module photovoltaïque **1.**

Sur la figure 1, le **module** photovoltaïque 1 comporte au moins un, et avantageusement plusieurs éléments photovoltaïques **1a** placés dans un même plan. Ces derniers sont reliés électriquement entre eux, en série ou en parallèle, et sont encapsulés, par exemple dans un polymère thermoplastique **1b, 1c** tel que l'éthylène acétate de vinyle (EVA) ou encore le silicone, pour former le module photovoltaïque **1.** La face avant **12** du module photovoltaïque **1** exposée au rayonnement est avantageusement recouverte d'une plaque transparente **1d,** comme par exemple une plaque de verre.

Une couche de matériau isolant électrique **1e** appelée « backsheet » est ajoutée sur la face arrière **11** du module photovoltaïque 1. Cette couche **1e** assure, en plus de l'isolation électrique, une fonction d'étanchéité entre le module photovoltaïque **1** et l'échangeur thermique **2.** Cette couche **1e** peut, par exemple, être un film de fluorure de polyvinyle, et permet d'empêcher la pluie et/ou l'humidité de l'air ambiant d'entrer en contact direct avec le module photovoltaïque **1,** évitant ainsi tout problème électrique, comme par exemple des faux contacts ou des courts circuits.

Ces différents éléments **1a, 1b, 1c, 1d, 1e** sont empilés sous forme de sandwich et sont maintenus ensemble par un procédé de lamination à chaud connu dans le domaine du photovoltaïque.

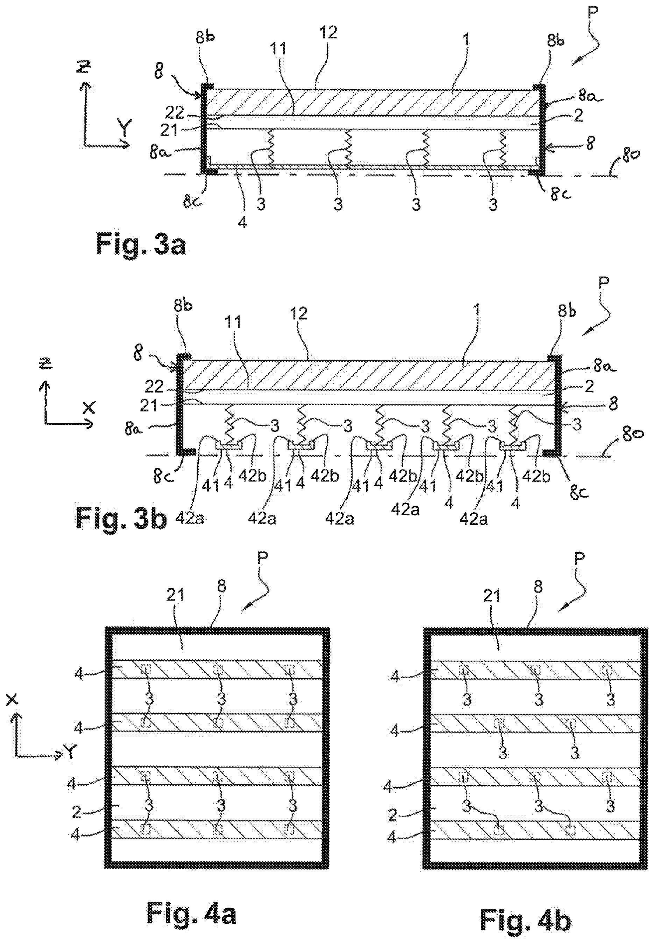

Sur les figures 3a et 3b, l'échangeur **2** est situé sous le module photovoltaïque **1** de manière à ne pas faire obstacle au rayonnement solaire. L'échangeur thermique **2** est avantageusement en matériau plastique, préférentiellement en polypropylène, mais il peut être en polyéthylène, en polyméthacrylate de méthyle, en polysulfure de phénylène, en polyphénylène oxyde, en polyphénylène éther, acrylonitrile butadiène styrène, ou encore toute autre matière convenant à l'Homme du métier. Il peut également être fabriqué dans d'autres types de matériau tel que le cuivre ou l'aluminium. Ces matériaux permettent de résister de manière pérenne à la corrosion générée par le fluide de refroidissement, ainsi qu'à des températures pouvant aller jusqu'à 90°C. L'échangeur **2** peut aussi se composer d'un polymère chargé, comme par exemple avec des fibres de verres, permettant ainsi d'améliorer sa rigidité.

Le fluide de refroidissement, qui est typiquement de l'eau, ou encore de l'eau glycolée, circule dans l'échangeur thermique **2** afin de récupérer les calories issues du module photovoltaïque **1.** Il circule toujours dans l'échangeur **2** depuis une zone d'entrée jusqu'à une zone de sortie. Ce type d'échangeur **2** est par exemple décrit dans le document brevet FR 2967817 (SOLAIRE 2G) auquel l'Homme du métier pourra se référer.

L'échangeur **2** est composé d'une face supérieure **22** plane destinée à être en contact avec la face arrière **11** du module photovoltaïque **1** et d'une face inférieure **21.** Les faces supérieure **22** et inférieure **21** sont préférentiellement planes et parallèles entre elles. La surface de la face inférieure **21** représente par exemple entre 10% à 100% de la surface totale du module photovoltaïque **1.** Elle peut, par exemple, avoir des dimensions (longueur et largeur) correspondant à celles du module photovoltaïque **1,** tous deux étant de forme générale rectangulaire. Elle a une longueur pouvant être comprise entre 150 cm et 400 cm, une largeur variant de 50 cm à 300 cm, et une épaisseur variant de 1 mm à 2 cm. Préférentiellement, pour une température de 20°C, la longueur de l'échangeur **2** représente 85% de la longueur du module photovoltaïque **1** et 95% de sa largeur.

Le panneau **P** comporte un cadre **8** qui est préférentiellement en aluminium ou en polymère, et peut, par exemple, être formé de profilés en U assemblés entre eux en utilisant différentes techniques d'assemblage, comme par exemple, par soudage ou par vissage. Les profilés en U peuvent également être assemblés les uns aux autres en encastrant chacun de leurs coins les uns dans les autres. De cette manière, les profilés sont solidaires les uns des autres sans nécessiter d'éléments d'assemblage supplémentaires.

En se rapportant aux figures annexées montrant le cadre **8** en coupe, notamment les figures 3a et 3b, les profilés en U formant ledit cadre présentent une âme **8a.** Laquelle âme **8a** est pourvue à chacune de ses extrémités d'une aile **8b, 8c.**

Le module photovoltaïque **1** est inséré dans le cadre **8,** au niveau des ailes supérieures **8b.** Le maintient en position du module photovoltaïque **1** dans le cadre **8** peut être réalisé par tous moyen convenant à l'homme du métier, notamment par vissage ou collage, ou en prévoyant une gorge dédiée dans les âmes **8a** dans laquelle se loge ledit module.

Conformément à l'invention, un dispositif permet de contraindre l'échangeur **2** contre la face arrière **11** du module photovoltaïque **1.** Ce dispositif se présente sous la forme d'une combinaison de moyens (décrits plus avant dans la description) comportant un ou plusieurs éléments d'appui **4** combinés à des éléments élastiques **3** venant en appui contre lesdits éléments d'appui **4.** Cette combinaison de moyens permet de plaquer efficacement et uniformément l'échangeur **2** contre le module photovoltaïque **1.** La présence des éléments élastiques **3** permet d'améliorer la performance du panneau solaire hybride **P** en amortissant efficacement les tolérances sur les cotes du cadre **8** ainsi que celles des éléments d'appui **4.** Ils permettent également d'amortir la flèche éventuelle des différents types d'éléments d'appui **4.**

Des exemples de modes de réalisation du dispositif de contrainte vont maintenant être décrits.

### Mode de réalisation n°1

Dans un premier mode de réalisation illustré sur les figures 2, 3a et 3b, le panneau solaire hybride **P** comporte plusieurs éléments d'appui **4** se présentant sous la forme de profilés. Le panneau **P** comporte au moins trois profilés **4** mais peut en compter plus. Ces profilés **4** sont placés sous l'échangeur **2,** en vis-à-vis de sa face inférieure **21,** et se répartissent sur toute sa surface. Préférentiellement, ils sont installés à intervalles réguliers, soit sur toute la longueur de l'échangeur **2,** soit sur toute sa largeur. Un tel aménagement permet une meilleure répartition des forces de compression appliquées par chacun des éléments élastiques **3,** un placage plus uniforme de l'échangeur **2** contre la face arrière **11** du module photovoltaïque **1** étant ainsi obtenu.

Le nombre de profilés **4** est choisi en fonction de la performance du panneau solaire hybride **P** souhaitée ainsi que de la flèche de l'échangeur **2.** En effet, plus le matériau dans lequel est fabriqué l'échangeur **2** est souple, plus les déformations sont importantes et plus le nombre d'éléments élastiques **3** nécessaire est important. Le nombre de profilés **4** étant, par conséquent, également plus important, les intervalles décrits précédemment seront réduits. Ils peuvent, par exemple, être compris entre 10 cm et 100 cm, préférentiellement égaux à 30 cm. Les profilés **4** sont installés de manière à être maintenus en place par le cadre **8.** Ainsi chacune des extrémités des profilés **4** est glissée dans le cadre **8.** Pour éviter que les profilés **4** ne soient délogés du cadre **8,** des moyens de fixation tels que de la colle, des vis, ou encore des adhésifs peuvent être utilisés. Sur les figures 3a et 3b, les profilés **4** sont insérés dans le cadre **8,** au niveau des ailes inférieures **8a,** et prennent appui au niveau de ces dernières. Ainsi, tout ou partie de la force de compression exercée par les éléments élastiques **3** sur les éléments d'appui **4** est reprise par le cadre **8** au niveau des ailes inférieures **8a.**

Les profilés **4** se présentent avantageusement sous la forme de barres de section carrée, rectangulaire, ou encore en forme de H, et ayant une longueur variant de 50 cm à 400 cm. Leur largeur est comprise entre 1 cm et 10 cm, et leur épaisseur varie de 2 mm à 5 cm. L'épaisseur des profilés **4** est choisie en fonction de la force des éléments élastiques **3** utilisés (décrits plus avant dans la description). En effet, la flèche des profilés **4** sous contrainte (après installation des éléments élastiques **3)** ne doit pas dépasser le retour (ou face inférieure) du cadre **8.** De cette manière, le point le plus bas de chacun des profilés **4** n'est pas plus bas que le retour du cadre **8.** En d'autres termes, et en se référant par exemple aux figures 3a et 3b, lorsque les profilés **4** sont sous contrainte et fléchissent, lesdits profilés ne dépassent pas du cadre **8** et notamment ne dépassent pas le plan **80** contenant la face inférieure dudit cadre. Ainsi, la face inférieure du cadre **8** peut être convenablement fixée sur un support standard de fixation lors de l'installation du panneau **P,** et notamment sur un support plan. En effet, dans la mesure où les profilés **4** ne dépassent pas le plan **80,** toute la face inférieure du cadre **8** est correctement positionnée en appui contre le support de fixation, sans contact ponctuel. Par exemple, la configuration (en particulier la section et/ou le module d'élasticité) des profilés **4** permet de limiter flèche desdits profilés. On notera que les panneaux solaires décrits dans l'article A. KROISS ET AL et dans le brevet US 2015/349178 précités, les profilés contre lesquels prennent appui les éléments élastiques sont situés hors du cadre de sorte que ce dernier ne peut pas être convenablement fixé sur des supports standards de fixation.

Sur la figure 3b, les profilés **4** se présentent préférentiellement sous la forme de profilés en U comportant une paroi de fond **41** et deux branches latérales **42a, 42b.** Les deux branches **42a, 42b** définissent une ouverture se plaçant en vis-à-vis de la face inférieure **21** de l'échangeur **2** lors de la conception du panneau solaire **P.** Cette ouverture permet d'insérer les éléments élastiques **3** afin qu'ils prennent appui contre la paroi du fond **41.** Ce type de profilés contribue à assurer le maintien en position des éléments élastiques **3** et à les cacher de manière à améliorer l'esthétisme du panneau **P** et les protéger d'erreurs de manutention potentielles.

Les éléments élastiques **3** se présentent préférentiellement sous la forme de ressorts hélicoïdaux de compression comportant une extrémité avant **32** et une extrémité arrière **31.** Ils peuvent, toutefois se présenter sous d'autres formes présentant la même fonction, comme par exemple des lames ressorts ou encore tout autre élément adapté pour exercer une force de compression sur l'échangeur 2. Ces ressorts **3** sont préférentiellement en acier inoxydable afin d'empêcher leur corrosion et augmenter leur durée de vie. Ils peuvent également être fabriqués en utilisant n'importe quel autre métal, et peuvent comporter un revêtement galvanisé ou non. Les ressorts **3** peuvent aussi être en plastique de manière à éviter toutes déperditions thermiques entre l'échangeur **2** et lesdits ressorts **3.** Les ressorts **3** en plastique permettent également d'éviter tout endommagement de la face inférieure **21** de l'échangeur **2.** Les ressorts **3** ont une hauteur comprise entre 5 mm et 5cm. Ils ont une force de compression comprise, entre 5 N et 70 N, de préférence entre 8 N et 12 N. Suivant la performance souhaitée pour le panneau solaire hybride **P,** une certaine tolérance concernant sa flèche est autorisée. Cette caractéristique détermine à la fois le nombre de ressorts **3** utilisés (comme décrit précédemment) et leur force. Les ressorts **3** choisis peuvent tous avoir la même force, mais ils peuvent également avoir des forces différentes. La force des ressorts **3** placés au niveau des zones d'entrée et sortie du liquide de refroidissement, peuvent par exemple, avoir une force supérieure à celle des ressorts **3** placés au niveau du centre de l'échangeur **2.**

Comme illustré sur les figures 3a et 3b, les ressorts **3** sont positionnés de sorte que leur extrémité arrière **31** soit en appui contre les profilés **4** et leur extrémité avant **32** exerce une force de compression sur la face inférieure **21** de l'échangeur **2.** Plusieurs ressorts **3** sont répartis dans la longueur de chacun des profilés **4** (figure 2), le nombre de ressorts **3** par profilé **4** pouvant varier de 2 à 15. Lors de l'utilisation du panneau **P,** l'échangeur **2** subit des déformations dues aux changements de température, notamment au niveau de sa longueur et sa largeur. La présence des ressorts **3** entre l'échangeur **2** et l'élément d'appui **4** rend possibles les déformations dues aux dilatations éventuelles de l'échangeur **2,** tout en le maintenant plaqué contre le module photovoltaïque **1.** De plus, l'élément d'appui **4** étant maintenu en place par le cadre **8,** lorsque les ressorts **3** exercent une force de compression sur ledit élément d'appui **4,** au moins une partie de cette force est reprise par ledit cadre **8.** Ainsi, la force de compression est transmise à chacune des extrémités du profilé **4,** celle-ci étant par conséquent, reprise par le cadre **8** dans lequel lesdites extrémités sont glissées.

En utilisant des profilés **4** en U, l'extrémité arrière **31** des ressorts **3** vient se loger contre la paroi de fond **41** et entre les deux branches **42a, 42b.** Cette configuration permet à la fois de protéger les ressorts **3** et améliorer l'esthétisme du panneau **P,** et d'éviter un déplacement latéral non désiré des ressorts **3** lors de l'utilisation du panneau solaire **P.**

Les ressorts **3** peuvent être répartis à l'arrière du panneau **P** de manière à ce qu'ils soient tous alignés (figure 4a), c'est-à-dire disposés en lignes et en colonnes. Toutefois, les ressorts **3** peuvent être disposés de manière décalée d'un profilé à l'autre (figure 4b) de sorte qu'en considérant la totalité desdits ressorts **3,** ceux-ci soient arrangés en quinconce. Cette configuration contribue à réduire la flèche de l'échangeur 2 sous l'effet des forces de compression des ressorts **3,** et par conséquent améliore l'homogénéité du placage dudit échangeur **2** contre le module photovoltaïque **1.**

Le panneau solaire **P** comporte au moins un élément de blocage **5** fixé à l'échangeur **2** et en interaction avec un profilé **4** pour bloquer l'échangeur **2** en translation dans le sens de la longueur (axe longitudinal X) et de la largeur (axe transversal Y) du panneau **P.** Préférentiellement, l'élément de blocage **5** est fixé à l'échangeur 2 au niveau du centre de sa face inférieure **21.** Cette configuration permet d'éviter tout risque de glissement de l'échangeur **2** sous son propre poids, à l'intérieur du cadre 8, pendant la manipulation du panneau **P** (lors des étapes comme par exemple l'emballage, le transport, ou encore l'installation).

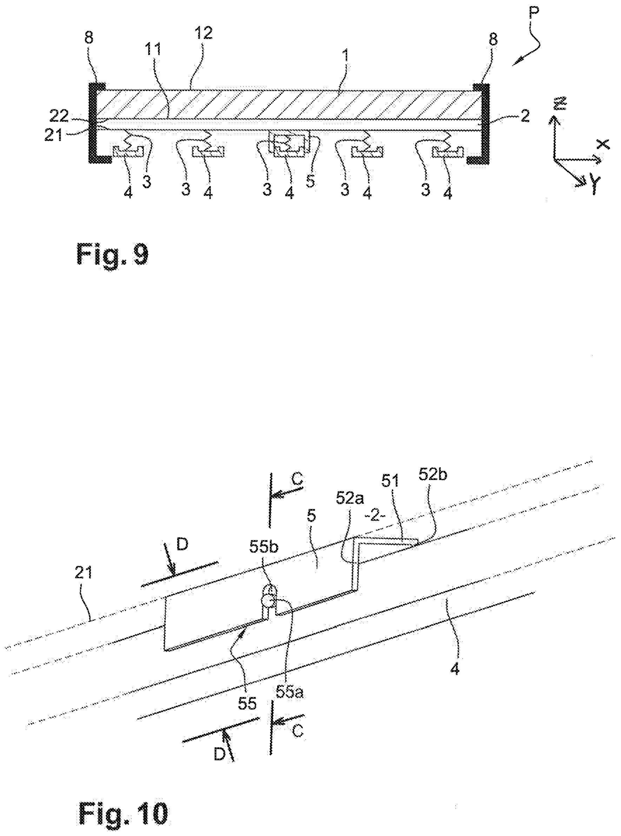

Les figures 9, 10, et 11 illustrent un exemple d'un tel élément de blocage **5.** Celui-ci se présente sous la forme d'un profilé en U comportant une paroi de fond **51** et deux parois latérales **52a, 52b.** La paroi de fond **51** est fixée au niveau de la face inférieure **21** de l'échangeur **2** grâce à des techniques de fixation telles que la soudure, ou encore le collage. Un des profilés **4** est glissé entre les parois **52a, 52b,** permettant ainsi de bloquer l'échangeur **2** en translation (selon les directions X et/ou Y). Une telle configuration évite que l'échangeur **2** ne se déplace et entraîne une détérioration des connectiques hydrauliques se trouvant à ses extrémités. De plus, en plaçant le moyen de blocage **5** au centre de la face inférieure **21** de l'échangeur **2,** une dilatation (due à l'élévation de température du module photovoltaïque **1** en présence de rayonnement solaire pendant le jour et à son refroidissement à température ambiante pendant la nuit) symétrique de l'échangeur **2** est rendue possible. Ainsi, lors de l'utilisation du panneau **P,** au lieu d'avoir une dilatation de x mm d'un seul côté de l'échangeur **2** (dans la largeur et dans la longueur), une dilatation de x/2 mm au niveau de chacun des côtés est observée.

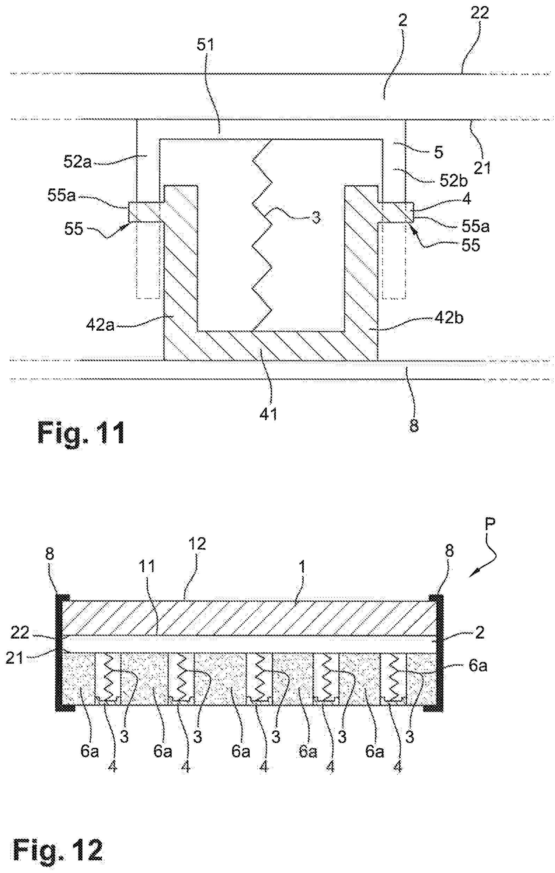

Sur les figures 10 et 11, le dispositif de contrainte comporte un assemblage **55** permettant de sécuriser davantage le profilé **4** en position lors de la conception du panneau **P.** Cet assemblage **55** comporte un élément mâle **55a** situé sur le profilé **4** qui coopère avec un élément femelle **55b** placé sur l'élément de blocage **5.** En particulier, au moins une, préférentiellement les deux branches **42a, 42b** du profilé **4,** comporte un élément mâle **55a** se présentant sous la forme d'un plot en saillie orienté vers l'extérieur du U. Parallèlement, l'élément de blocage **5** comporte une rainure **55b** correspondante dans laquelle vient se loger le plot **55a.**

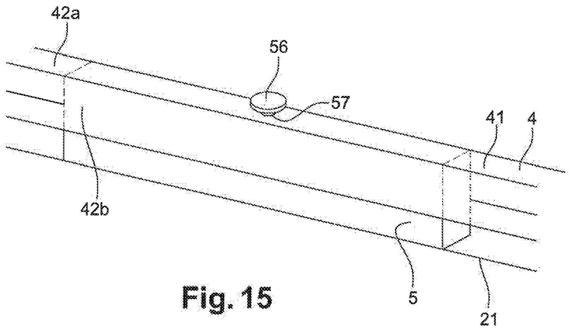

Dans un mode de réalisation alternatif représenté à la figure 15, l'élément de blocage **5** est un pavé de section rectangulaire venant se glisser dans le profilé **4.** Ce pavé à une longueur variant de 2 cm à 5 cm et une largeur correspondant à celle du profilé **4** (comprise entre 1 cm et 10 cm). Un élément de fixation **56** comme par exemple une goupille, ou encore un clou (par exemple un clou cannelé en acier inoxydable) est inséré dans un orifice **57** effectué dans le profilé **4** et étant placé dans l'alignement d'un orifice (non représenté) réalisé dans le pavé **5.** L'élément de fixation **56** est solidarisé à la face inférieure **21** de l'échangeur **2.** Cette configuration empêche le pavé **5** (et donc l'échangeur **2)** de bouger en translation le long dudit profilé **4,** alors que les branches **42a, 42b** du U l'empêchent de bouger transversalement.

Sur la figure 12, le panneau **P** comporte un élément thermiquement isolant **6a** permettant de réduire les déperditions thermiques au niveau de la face inférieure **21** de l'échangeur **2,** pour améliorer la récupération de chaleur par ledit échangeur **2,** et par conséquent augmenter le rendement dudit panneau **P.** L'élément thermiquement isolant **6a** peut, par exemple, se présenter sous la forme d'un matériau non solide tel que la laine de verre ou la laine de roche. Dans ce cas de figure, l'élément isolant **6a** est placé entre les différents éléments d'appui **4.** Il est maintenu en position par une plaque de fond (non représentée) fixée aux profilés **4** et/ou au cadre **8.** Cette plaque peut, par exemple, être fixée aux profilés **4** et/ou au cadre **8** grâce à des vis ou boulons, des adhésifs, ou encore par soudage, collage.

L'élément isolant **6a** peut également se présenter sous la forme de plaques de matériau solide tel que le polystyrène, le polyuréthane, le polyéthylène, ou encore le polypropylène. Ces plaques sont disposées entre les profilés **4** et peuvent être glissées en partie sous le cadre **8** de manière à être naturellement maintenues en position. Elles peuvent également être fixées sur les parois latérales **42a, 42b** des profilés grâce à des moyens tels que de la colle, ou encore des adhésifs.

### Mode de réalisation n°2

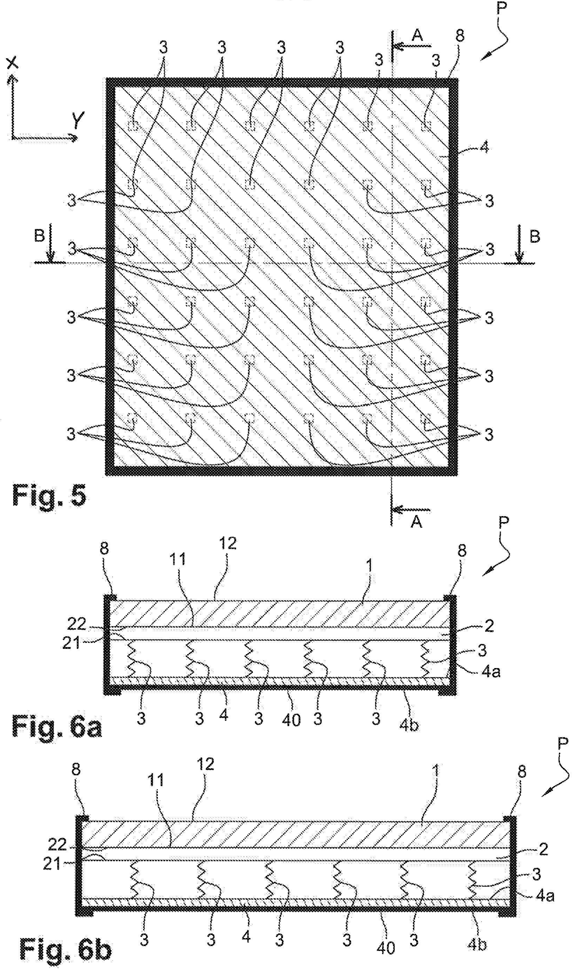

Les figures 5, 6a et 6b décrivent un deuxième mode de réalisation dans lequel l'élément d'appui **4** se présente sous la forme d'une plaque. Elle est disposée sous l'échangeur **2** et s'étend préférentiellement sur toute la surface de la face inférieure **21** dudit échangeur **2.** Cette plaque **4** est fabriquée dans un matériau rigide tel qu'un matériau polymère (polystyrène, polyuréthane, polyéthylène, etc.) ou encore un métal. L'extrémité arrière **32** des ressorts **3** prend appui sur la face supérieure **41** de ladite plaque **4** alors que leur extrémité avant **31** est placée contre la face inférieure **21** de l'échangeur **2,** permettant ainsi d'appliquer une force de compression sur ce dernier et de le plaquer contre la face arrière **11** du module photovoltaïque **1.** La plaque **4** a des dimensions en longueur et en largeur similaires à celles de la face inférieure **21** l'échangeur **2.** Elle a une longueur comprise entre 150 cm et 400 cm et une largeur variant de 50 cm à 300 cm. Son épaisseur dépend du matériau utilisé et est comprise entre 2 mm et 4 cm. De façon équivalente à celle décrite pour le mode de réalisation précédent, l'épaisseur va dépendre de la flèche du panneau **P.** Elle est choisie de façon à s'assurer que le point le plus bas soit le retour du cadre **8.**

De la même manière que dans le premier mode de réalisation, la plaque **4** est glissée dans le cadre **8** de manière à être maintenue en position. Cette plaque **4** peut être maintenue uniquement au niveau de ses bords latéraux. Elle peut, toutefois, être maintenue au niveau des bords longitudinaux, ou sur son périmètre entier. Elle peut également être solidarisée au cadre **8** grâce à des moyens de fixation tels que de la colle, des adhésifs, ou encore des vis ou des boulons. Une telle configuration permet qu'au moins une partie de la force de compression exercée par les ressorts **3** sur la plaque **4,** soit reprise par le cadre **8.** Selon un mode préféré de réalisation, la plaque **4** est insérée dans le cadre **8,** au niveau des ailes inférieures **8a,** et prend appui au niveau de ces dernières. Ainsi, tout ou partie de la force de compression exercée par les éléments élastiques **3** sur la plaque **4** est reprise par le cadre **8** au niveau des ailes inférieures **8a.**

Dans un mode de réalisation préféré, la plaque **4** est en nid d'abeille. Ce type de plaque permet, en plus de rigidifier davantage le panneau **P,** de ne pas avoir à utiliser d'isolant supplémentaire (décrit plus avant dans la description) puisque la plaque en nid d'abeille rempli une double fonction consistant à permettre aux ressorts **3** prendre appui et d'isoler le panneau solaire **P.**

Comme décrit précédemment en référence au mode de réalisation n°1, lorsque la plaque **4** est sous contrainte et fléchie, ladite plaque ne dépasse pas du cadre **8** et notamment ne dépassent pas le plan **80** contenant la face inférieure dudit cadre. Par exemple, l'utilisation d'une plaque **4** en nid d'abeille permet de limiter flèche de ladite plaque.

Les ressorts **3** utilisés sont les mêmes que ceux décrits dans le mode de réalisation précédent. Ils sont, de préférence, répartis uniformément sur toute la surface de la plaque **4,** mais peuvent éventuellement être placés aléatoirement. Comme décrit pour le mode précédent, un aménagement en quinconce contribue à réduire la flèche de l'échangeur **2,** et par conséquent améliore l'homogénéité du placage dudit échangeur **2** contre le module photovoltaïque **1.**

Ce mode de réalisation peut, le cas échéant, comporter un élément thermiquement isolant supplémentaire tel que celui décrit pour le mode de réalisation précédent pour réduire les déperditions thermiques au niveau de l'échangeur **2.** Sur les figures 6a et 6b, l'élément isolant se présente sous la forme d'une plaque **40** venant se placer sous la plaque **4,** et plus particulièrement contre sa face inférieure **4b,** de manière à améliorer l'isolation thermique du panneau solaire **P.** Cette plaque isolante **40** est fabriquée dans un matériau similaire à ceux décrits pour **le** mode de réalisation précédent. Elle peut être, par exemple, fixée sur la plaque **4** grâce à des moyens de fixation comme une soudure, ou un collage, ou encore en utilisant des adhésifs. Elle est présente sur toute la face inférieure **4a** de la plaque **4** avec une longueur comprise entre 150 cm et 400 cm, une largeur variant de 50 cm à 300 cm. Son épaisseur est comprise entre 2 mm et 15 cm suivant le matériau utilisé.

Comme décrit précédemment en référence au mode de réalisation n°1, on utilise avantageusement un élément de blocage fixé à l'échangeur **2** et en interaction avec la plaque **4** pour bloquer l'échangeur **2** en translation dans le sens de la longueur (axe longitudinal X) et de la largeur (axe transversal Y) du panneau **P.** Cet élément de blocage **5** est similaire à celui décrit sur les figures 10 ou 15.

### Mode de réalisation n°3

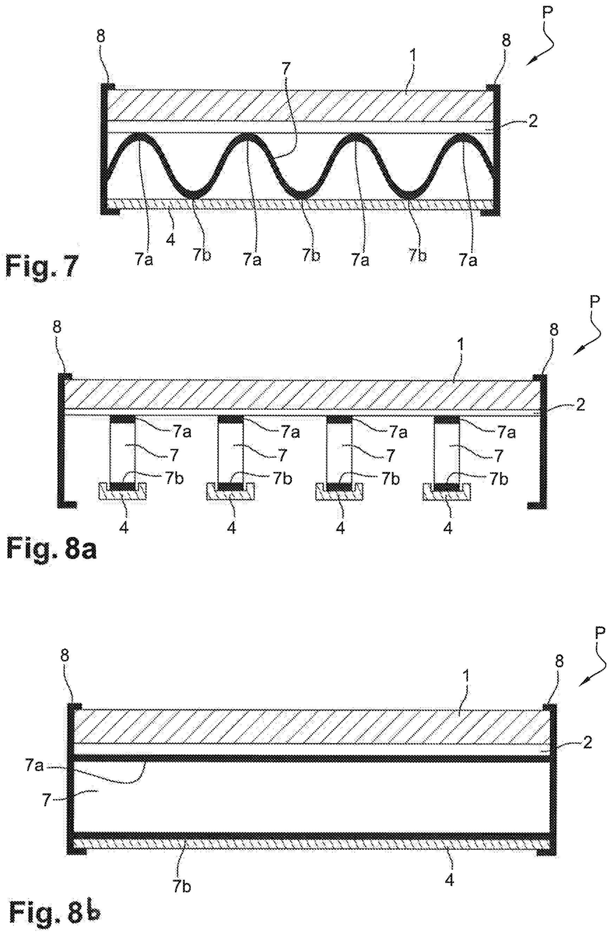

Les figures 7 et 8a décrivent un mode de réalisation supplémentaire équivalent au mode de réalisation n°1 décrit précédemment. L'insertion des éléments d'appui **4** dans le cadre **8** et l'utilisation de l'élément de blocage **5** s'appliquent à ce mode de réalisation.

Les ressorts **3** sont remplacés par une bande ondulée **7.** Cette bande est fabriquée dans un matériau semi rigide de sorte qu'elle puisse être sensiblement déformable au cours de l'utilisation du panneau solaire P. Ce matériau peut, par exemple, être du polyéthylène, du polystyrène, du polyuréthane, etc.

Comme le montre la figure 8a, chacune des bandes ondulées **7** comporte des ondulations ayant des points hauts **7a** et des points bas **7b.** Les points hauts de la bande ondulée **7** sont en contact avec la face inférieure **21** de l'échangeur **2** et permettent de plaquer celui-ci contre la face arrière **11** du module photovoltaïque **1.** Les ondulations servent d'éléments élastiques **3** et permettent d'exercer une force de compression contre l'échangeur **2** en des points multiples, améliorant ainsi l'uniformité du placage. Les points bas **7b** sont en appui contre les profilés **4.** Cette configuration permet une conception plus rapide du panneau puisque, à la place de ressorts multiples, une seule bande **7** est installée dans chacun des profilés. De plus, l'utilisation d'une telle bande ondulée **7** évite la détérioration de la face inférieure **21** de l'échangeur pouvant subvenir lors de l'utilisation de ressorts. Additionnement, le coût de revient d'une telle bande **7** est diminué par rapport à l'utilisation des ressorts.

### Mode de réalisation n°4

La figure 8b illustre une variante du mode de réalisation n°2 décrit précédemment. L'insertion de la plaque **4** dans le cadre **8** et l'utilisation de l'élément de blocage **5** s'appliquent à ce mode de réalisation.

Les ressorts sont remplacés par au moins une plaque ondulée **7.** Cette plaque **7** peut, comme illustré sur la figure 8b, s'étendre sur toute la face inférieure **21** de l'échangeur **2.** Alternativement, des plaques **7** de taille plus réduite peuvent être réparties de manière homogène sur toute la surface de la face inférieure **21.** Préférentiellement, elles sont installées à intervalles réguliers, soit sur toute la longueur de l'échangeur **2,** soit sur toute sa largeur.

La plaque ondulée **7** a des dimensions correspondant à celles de l'échangeur **2.** Sa longueur varie de 150 cm à 400 cm et sa largeur est comprise entre 5 cm et 300 cm. Elle a une épaisseur, dépendante du matériau utilisé, pouvant varier de 1 mm à 4 cm.

De la même manière que pour le mode de réalisation n°3, la plaque **7** comporte des ondulations ayant des points hauts **7a** et des points bas **7b.** Les points hauts de la plaque ondulée **7** sont en contact avec la face inférieure **21** de l'échangeur **2** et permettent de plaquer celui-ci contre la face arrière **11** du module photovoltaïque **1.** Les ondulations servent d'éléments élastiques **3** et permettent d'exercer une force de compression contre l'échangeur **2** en des points multiples, améliorant ainsi l'uniformité du placage. Les points bas **7b** sont en appui contre la plaque **4.**

Dans les modes de réalisation n°1 et n°2 comportant des éléments élastiques **3** se présentant sous la forme de ressorts, le panneau solaire **P** peut posséder des moyens de protection **9a, 9b.** Ces moyens de protection **9a, 9b** sont placés entre la face inférieure **21** de l'échangeur **2** et les extrémités avants **32** de chacun des ressorts **3.** Ces moyens de protection **9a, 9b** permettent d'éviter que les ressorts **3** ne transpercent la face inférieure **21** de l'échangeur **2.**

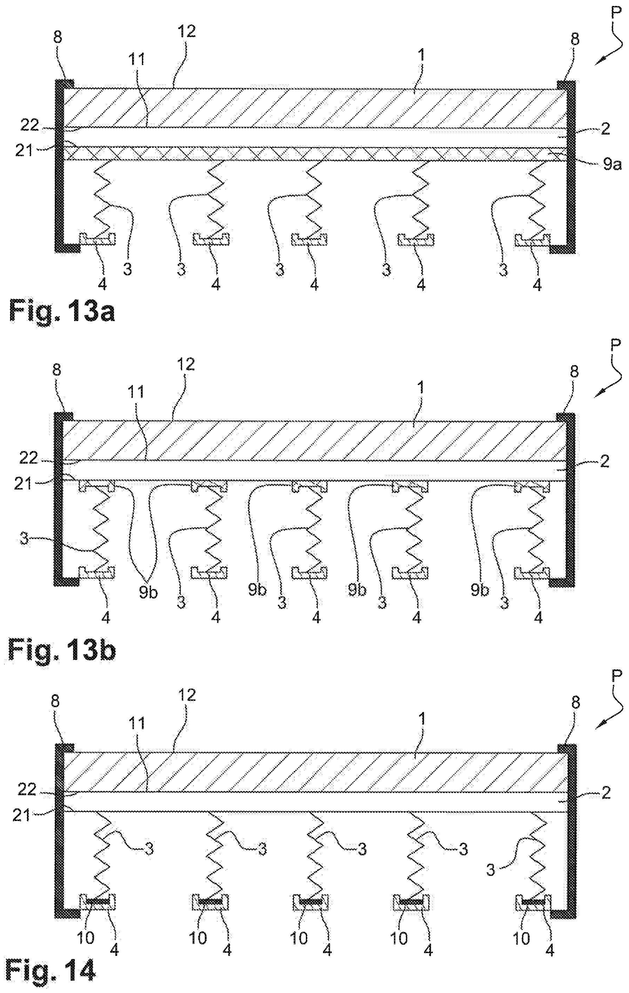

Ces moyens de protection peuvent se présenter sous la forme d'une plaque **9a** se positionnant sous l'échangeur **2** (figure 13a). Cette plaque **9a** a des dimensions similaires à celles de l'échangeur **2** précisées précédemment. Elle peut être fabriquée dans n'importe quel type de matériau, comme par exemple l'acier, l'aluminium, ou encore un plastique ou une mousse. Ces moyens de protection peuvent également se présenter sous la forme de coupelles **9b** (figure 13b) à fond plat. De la même manière que la plaque **9a,** ces coupelles **9b** peuvent être fabriquées dans n'importe quel matériau. Elles ont un diamètre compris entre 1 cm et 10 cm et une épaisseur, dépendante du matériau utilisé, variant de 1 mm à 1 cm. Alternativement, ces moyens de protection peuvent se présenter sous la forme de coussinet, comme par exemple d'éléments en mousse, de préférence des coussinets en mousse. La forme des éléments en mousse et/ou des coupelles peut être variée, comme par exemple un carré, une étoile, un rond, ou encore un rectangle.

L'agencement des différents éléments et/ou moyens et/ou étapes de l'invention, dans les modes de réalisation décrits ci-dessus, ne doit pas être compris comme exigeant un tel agencement dans toutes les implémentations. En tout état de cause, on comprendra que diverses modifications peuvent être apportées à ces éléments et/ou moyens et/ou étapes, sans s'écarter de l'esprit et de la portée de l'invention. En particulier :
- l'échangeur thermique **2** peut être fabriqué dans un matériau différent, comme par exemple en métal (tel que l'acier, l'acier inoxydable, l'aluminium, ou le cuivre), ou encore en matériau composite,
- un élément de maintien **10** peut être ajouté entre l'élément élastique **3** et l'élément d'appui **4** (figure 14) de sorte à maintenir ledit élément élastique **3** en position. Il peut se présenter, par exemple, sous la forme d'un adhésif ou encore sous la forme d'un clip,
- l'extrémité avant **32** de chacun des ressorts **3** peut être meulée de manière à ne pas rayer ni transpercer la face inférieure **21** de l'échangeur **2,**
- il peut y avoir ou non une plaque supplémentaire entre le module photovoltaïque **1** et l'échangeur **2,**
- la plaque **4** et la plaque ondulée **7** peuvent avoir des dimensions différentes de celles mentionnées précédemment, elles peuvent, par exemple ne couvrir que la moitié ou le tiers de la surface de l'échangeur **2,**
- la fréquence des ondulations de la plaque et/ou de la bande ondulée **7** peut varier.

## Revendications

1. Panneau solaire hybride (P) comprenant :
- un module photovoltaïque (1) comportant une face avant (12) et une face arrière (11),
- un échangeur thermique (2) comportant une face inférieure (21) et une face supérieure (22), ladite face supérieure (22) étant disposée en vis-à-vis de la face arrière (11) du module photovoltaïque (1),
- un cadre rigide (8) encadrant le module photovoltaïque (1) et l'échangeur thermique (2),
- des éléments élastiques (3) adaptés pour exercer une force de compression contre la face inférieure (21) de l'échangeur (2) de sorte que ledit échangeur (2) soit plaqué contre la face arrière (11) du module photovoltaïque (1),
- les éléments élastiques (3) prennent appui contre au moins un élément d'appui (4), ledit élément d'appui (4) étant en liaison avec le cadre (8) de sorte qu'au moins une partie de la force de compression exercée par lesdits éléments élastiques (3) sur l'élément d'appui (4) soit reprise par ledit cadre (8),
- l'élément d'appui (4) est disposé sous l'échangeur (2) et s'étend dans la largeur et/ou la longueur dudit échangeur (2),
**caractérisé en ce que** :
- ledit panneau comporte au moins trois éléments d'appui (4) disposés sous l'échangeur (2) et qui s'étendent chacun dans la largeur dudit échangeur (2) ou respectivement dans la longueur dudit échangeur (2), lesquels éléments d'appui (4) se présentent sous la forme de profilés installés à intervalles réguliers dans la longueur dudit échangeur (2), ou respectivement dans la largeur dudit échangeur (2),
- le cadre (8) présente une face inférieure adaptée pour être positionnée contre un support de fixation du panneau (P),
- les éléments d'appui (4) sont configurés de sorte que lorsque lesdits éléments d'appui sont contraints par les éléments élastiques (3), ils ne dépassent pas le plan (80) contenant la face inférieure dudit cadre.

2. Panneau solaire hybride (P) selon la revendication 1, **caractérisé en ce que** plusieurs éléments élastiques (3) sont répartis dans la longueur de chaque profilé (4).

3. Panneau solaire hybride (P) selon la revendication 2, **caractérisé en ce que** les éléments élastiques (3) sont répartis dans chacun des profilés (4) de manière à ce que lesdits éléments élastiques (3) soient arrangés en quinconce en considérant l'ensemble desdits profilés (4).

4. Panneau solaire hybride (P) selon l'une des revendications 1 à 3, **caractérisé en ce que** l'élément d'appui (4) se présente sous la forme d'un profilé en U délimité par une paroi de fond (41) et deux branches latérales (42a, 42b), lesquelles branches définissent une ouverture au niveau de leur extrémité libre, lequel profilé est agencé de sorte que ladite ouverture soit dirigée vers la face inférieure (21) de l'échangeur (2), l'élément élastique (3) prenant appui sur la paroi de fond (41) dudit profilé.

5. Panneau solaire hybride (P) selon l'une des revendications 1 à 3, **caractérisé en ce que** l'élément d'appui (4) se présente sous la forme d'une plaque disposée sous l'échangeur (2) et qui s'étend sur toute la surface de la face inférieure (21) dudit échangeur (2).

6. Panneau solaire hybride (P) selon la revendication 5, **caractérisé en ce que** l'élément d'appui (4) est en nid d'abeille.

7. Panneau solaire hybride (P) selon l'une des revendications 1 à 6, **caractérisé en ce que** chaque élément élastique (3) se présente sous la forme d'un ressort hélicoïdal de compression.

8. Panneau solaire hybride (P) selon l'une des revendications 1 à 6, **caractérisé en ce qu'il** comprend une plaque ondulée installée entre l'élément d'appui (4) et la face inférieure (21) de l'échangeur (2), ladite plaque ondulée étant configurée de sorte que ses ondulations forment les éléments élastiques (3).

9. Panneau solaire hybride (P) selon l'une des revendications 1 à 8, **caractérisé en ce que** l'élément élastique (3) comporte une extrémité avant (32) et une extrémité arrière (31), un moyen de protection étant placé entre la face inférieure (21) de l'échangeur (2) et ladite extrémité avant (32).

10. Panneau solaire hybride (P) selon la revendication 9, **caractérisé en ce que** le moyen de protection se présente sous la forme d'une plaque rigide installée entre la face inférieure (21) de l'échangeur (2) et l'extrémité avant (32) de l'élément élastique (3) ou le moyen de protection se présente sous la forme d'une coupelle placée entre la face inférieure (21) de l'échangeur (2) et l'extrémité avant (32) de l'élément élastique (3), ou le moyen de protection se présente sous la forme d'un élément en mousse placé entre la face inférieure (21) de l'échangeur (2) et l'extrémité avant (32) de l'élément élastique (3).

11. Panneau solaire hybride (P) selon l'une des revendications 1 à 10, **caractérisé en ce qu'un** élément de maintien est placé entre l'extrémité arrière (31) de l'élément élastique (3) et l'élément d'appui (4).

12. Panneau solaire hybride (P) selon la revendication 11, **caractérisé en ce que** l'élément de maintien est un élément adhésif.

13. Panneau solaire hybride (P) selon l'une des revendications 1 à 4, **caractérisé en ce qu'un** élément thermiquement isolant (6a) est interposé entre les éléments d'appui (4).
